# EUROPÄISCHE PATENTSCHRIFT

(11) **EP 1 508 168 B1**
(45) Veröffentlichungstag und Bekanntmachung des Hinweises auf die Patenterteilung: **13.12.2017**
(21) Anmeldenummer: 03704305.6
(22) Anmeldetag: 10.02.2003
(51) Int. Cl.: H01L 23/482, H01L 23/488, H01L 25/07, H01L 23/373

(54) **HALBLEITERBAUELEMENT UND VERFAHREN ZUM HERSTELLEN EINER HALBLEITERBAUELEMENTANORDNUNG MIT DEM HALBLEITERBAUELEMENT**
SEMICONDUCTOR COMPONENT AND METHOD OF MAKING A SEMICONDUCTOR COMPONENT ASSEMBLY INCLUDING SAID SEMICONDUCTOR COMPONENT
COMPOSANT SEMI-CONDUCTEUR ET PROCÉDÉ DE FABRICATION D'UN ENSEMBLE DE COMPOSANTS SEMI-CONDUCTEURS COMPRENANT LEDIT COMPOSANT SEMI-CONDUCTEUR

(30) Priorität: 11.05.2002 DE 10221082
(43) Veröffentlichungstag der Anmeldung: 23.02.2005
(73) Patentinhaber: ROBERT BOSCH GMBH, 70442 Stuttgart (DE)
(72) Erfinder: HAUENSTEIN, Henning, 72762 Reutlingen (DE); TOPP, Rainer, 72768 Reutlingen (DE); SEIBOLD, Jochen, 72070 Tuebingen (DE); BALSZUNAT, Dirk, 70569 Stuttgart (DE); ERNST, Stephan, 73760 Ostfildern (DE); FEILER, Wolfgang, 72766 Reutlingen (DE); KOESTER, Thomas, 72770 Reutlingen (DE); HORNUNG, Stefan, 70771 Leinfelden (DE); STREB, Dieter, 72770 Reutlingen (DE)
(86) Internationale Anmeldenummer: PCT/DE2003/000376
(87) Internationale Veröffentlichungsnummer: WO 2003/096415

(56) Entgegenhaltungen:
- WO-A-99/26295
- FR-A- 2 814 907
- US-A- 4 419 810
- US-A- 5 313 088
- US-A- 6 072 240

## Beschreibung

Die Erfindung betrifft ein Halbleiterbauelement, das insbesondere für Leistungsanwendungen verwendbar ist.

Bei Leistungsbauelementen, insbesondere Leistungstransistoren, mit einem vertikalen Aufbau ist auf einer ersten Seite (Oberseite) des Halbleiter-Chips eine erste Hauptelektroden-Metallisierung und die Steuerelektroden-Metallisierung und auf einer zweiten Seite (Rückseite) des Halbleiter-Chips die zweite Hauptelektroden-Metallisierung ausgebildet. Die Verlötung mit einer Anschlusseinrichtung bzw. einem Anschlussgitter - in der Regel einem Substrat oder Tape (flexible Folie) - kann für die größere zweite Hauptelektroden-Metallisierung, z. B. eine Source-Metallisierung mit einer Fläche von 20 mm², durch Zwischenlegen einer großflächigen Lötfolie oder durch einen Lötpastendruck auf das Anschlussgitter schnell, einfach und kostengünstig erfolgen. Die Steuerelektroden-Metallisierung ist mit einer Fläche von zum Bespiel 1 mm² oder weniger sehr klein ausgebildet. Um bei der Lotbeschichtung eine hinreichende Positionsgenauigkeit sicherzustellen, muss das Lot somit zumindest auf der strukturierten Vorderseite des Halbleiter-Chips in einem zusätzlichen aufwendigen, komplexen und kostenträchtigen Prozessschritt in Löt-Bumps (Löt-Höckern) vorab aufgebracht werden. Nachfolgend werden die Anschlusseinrichtungen mit dem dazwischen aufgenommenen Halbleiter-Chip in einem Lötofen veríötet.

Hierbei können auch mehrere Halbleiter-Chips in lateraler Richtung nebeneinander gesetzt und zwischen gemeinsamen Anschlusseinrichtungen verlötet werden. Die US 6,072,240 zeigt ein derartiges Halbleiterbauelement und das Verfahren zu seiner Herstellung, bei dem Transistoren in reverser Anordnung zwischen gemeinsamen Substraten verlötet werden.

Das erfindungsgemäße Halbleiterbauelement nach Anspruch 1 und das erfindungsgemäße Verfahren nach Anspruch 11 weisen demgegenüber insbesondere den Vorteil auf, dass eine relativ einfache, schnelle und dennoch sichere Herstellung des Halbleiterbauelementes ermöglicht wird. Hierbei kann durch Ausbildung einer Isolationsschicht und zusätzlicher Metallschichten bzw. Metallebenen auf der Vorderseite des Halbleiter-Chips der zusätzliche Schritt des Aufbringens von Löt-Bumps entfallen. Die Unteransprüche beschreiben bevorzugte Weiterbildungen. Gemäß Anspruch 4 wird insbesondere eine Halbleiterbauelementanordnung aus mindestens einem erfindungsgemäßen Halbleiterbauelement und mindestens einer mit diesem verlöteten Anschlusseinrichtung geschaffen.

Erfindungsgemäß wird somit auf der ersten Seite des Halbleiter-Chips eine Isolationsschicht zwischen der ersten Hauptelektrodenschicht und Gate-Elektrodenschicht aufgetragen, die die - bereits bei herkömmlichen Bauelementen verwendete - untere erste Haupteiektrodenschicht teilweise bedeckt. Nachfolgend werden erfindungsgemäß obere Elektrodenschichten bzw. Metallebenen auf die unteren Elektrodenschichten der ersten Seite aufgetragen, wobei die obere Steuerelektrodenschicht bzw. Gate-Elektrodenschicht wesentlich großflächiger als die untere Steuerelektrodenschicht ausgebildet werden kann, indem sie über einen größeren Bereich der Isolationsschicht, auch oberhalb des überlappten Bereichs der unteren ersten Hauptelektrodenschicht, ausgebildet wird. Durch die Ausbildung einer geeigneten Isolationsschicht kann somit eine gewünschte Dimensionierung der oberen Elektrodenschichten bzw. oberen Metallebenen erreicht werden, die eine größere Fläche für das aufzunehmende Lot aufweisen. Hierdurch kann das Lot - wie auch auf der zweiten Seite bzw. Unterseite des Halbleiter-Chips - durch eine dazwischengelegte Lötfolie oder eine auf die Anschlusseinrichtung aufgetragene, z. B. aufgedruckte Lötpaste vorgesehen werden.

Die sich ergebenden Abstufungen der Elektrodenschichten, insbesondere auch innerhalb der oberen Steuerelektrodenschicht, werden grundsätzlich bereits durch das beim Montage-Prozess ausschmelzende Lot ausgeglichen; zusätzlich kann ein ergänzendes Verfahren zur Chip-Oberflächen. Planarisierung, zum Beispiel durch partielles Einfügen einer oder mehrerer Zwischenoxidschichten, durchgeführt werden.

Als Anschlusseinrichtung bzw. Anschlussgitter können sowohl Keramik-Substrate als auch flexible Folien bzw. Tapes mit entsprechend dimensionierten leitfähigen Anschlussbereichen verwendet werden. Es können insbesondere ein oder zwei DBC (Direct Bonded Copper)-Substrate verwendet werden, das/die eine weitere Metallschicht auf der Außenseite des erfindungsgemäß gebildeten Bauelementes aufweist bzw. aufweisen.

Erfindungsgemäß können insbesondere zwei oder mehr Halbleiter-Chips nebeneinander zwischen zwei Anschlusseinrichtungen verlötet werden. Hierbei können zum Beispiel zwei oder mehr Transistoren in reverser Anordnung verlötet werden, wobei durch die leitfähigen Anschlussbereiche auf den Anschlusseinrichtungen eine Kontaktierung bzw. Verbindung der Elektroden der Transistoren gebildet werden kann.

Neben Feldeffekt-Transistoren können erfindungsgemäß grundsätzlich auch andere Halbleiterbauelemente, zum Beispiel Bipolartransistoren oder Thyristoren, geschaffen werden.

Die Erfindung wird im Folgenden anhand der beiliegenden Zeichnungen an einer Ausführungsform näher erläutert. Es zeigen:
- Fig. 1 -: eine Schnittansicht durch einen in dem erfindungsgemäßen Halbleiterbauelement verwendeten Leistungstransistor;
- Fig. 2 -: eine Draufsicht auf den Leistungstransistor von Fig. 1;
- Fig. 3 -: eine Schnittansicht eines Bauelementes vor der Verlötung;
- Fig. 4 -: eine Schnittansicht des Bauelementes von Fig. 3 nach der Verlötung.

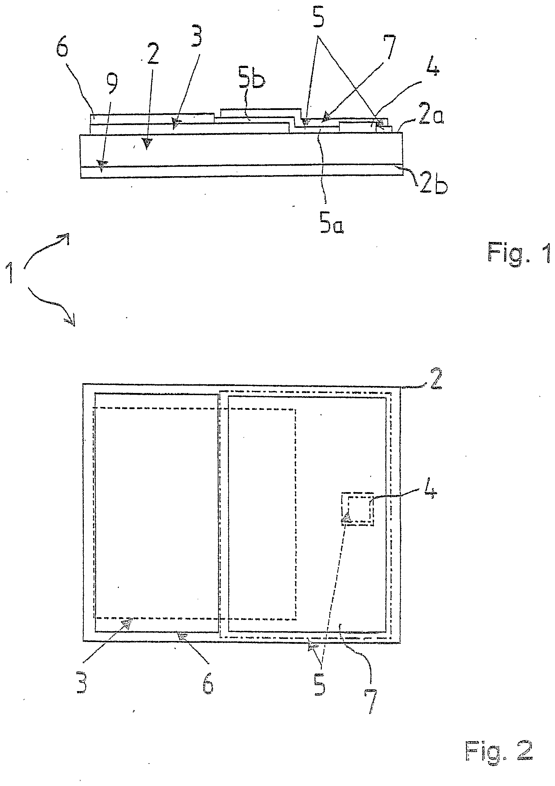

Ein Leistungstransistor 1 weist gemäß Fig. 1, Fig. 2 einen Silizium-Chip 2 mit vertikalem Aufbau auf, in dem nicht weiter gezeigte dotierte Bereiche strukturiert sind. Auf einer Oberseite 2a des Silizium-Chips 2 ist oberhalb eines Source-Bereichs eine untere Source-Metalischicht 3 als untere erste Hauptelektrodenschicht aufgetragen. In lateraler Richtung hierzu beabstandet ist eine untere Gate-Metallschicht 4 als untere Steuerelektrodenschicht aufgetragen. Auf der zweiten Seite bzw. Unterseite 2b des Silizium-Chips 2 ist auf einem Drain-Bereich eine Drain-Metallschicht 9 als zweite Hauptelektrodenschicht aufgetragen.

Erfindungsgemäß ist eine Isolationsschicht 5 - zum Beispiel aus Siliziumdioxid - auf der Oberseite 2a derartig aufgetragen, dass sie sich mit ihrem Teilbereich 5a zwischen der unteren Source-Metallschicht 3 und der unteren Gate-Metallschicht 4 erstreckt und weiterhin mit ihrem Teilbereich 5b einen Bereich der unteren Source-Metalschicht 3 bedeckt. Eine obere Source-Metallschicht 6 bedeckt den freigelassenen Bereich der unteren Source-Metallschicht 3 und grenzt lateral an die Isolationsschicht 5 an. Auf der Isolationsschicht 5 ist eine obere Gate-Metallschicht 7 aufgetragen, die die Teilbereiche 5a und 5b sowie die untere Gate-Metallschicht 4 bedeckt.

Gemäß einem nachfolgenden Verfahrensschritt werden zwei Leistungstransistoren 11 und 12 mit dem in den Fig. 1, 2 gezeigten Aufbau und entsprechenden Bezugszeichen in reverser Anordnung lateral zueinander beabstandet zwischen einem ersten DBC-Substrat 30 und einem zweiten DBC-Substrat 40 positioniert. Die DBC-Substrate 30, 40 weisen auf ihren inneren, d. h. zu den Halbleiter-Chips 11, 12 hingewandten Seiten jeweils eine als leitfähige Anschlussschicht dienende erste Kupferschicht 32, 42 auf, die den oberen Source-Metallschichten 16, 26 gegenüberliegen. Weiterhin sind an den inneren Seiten der DBC-Substrate 30, 40 zweite Kupferschichten 33, 43 vorgesehen und derartig positioniert, dass jede zweite Kupferschicht 33 bzw. 43 der Drain-Metallschicht 29 bzw. 19 und der oberen Gate-Metallschicht 17 bzw. 27 gegenüberliegt. Zwischen jeder der oberen Source-Metallschichten 16 bzw. 26 und der jeweiligen ersten Kupferschicht 32, 42 ist eine Lötfolie 35 bzw. 45 positioniert. Entsprechend sind Lötfolien 36 bzw. 46 zwischen der oberen Gate-Metallschicht 17 bzw. 27 und der zweiten Kupferschicht 33 bzw. 43 und Lötfolien 47 bzw. 37 zwischen den Drain-Metallschichten 19 bzw. 29 und den zweiten Kupferschichten 33 bzw. 43 positioniert. An den äußeren Seiten der DBC-Substrate 30, 40 sind weitere Kupferschichten 34, 44 ausgebildet.

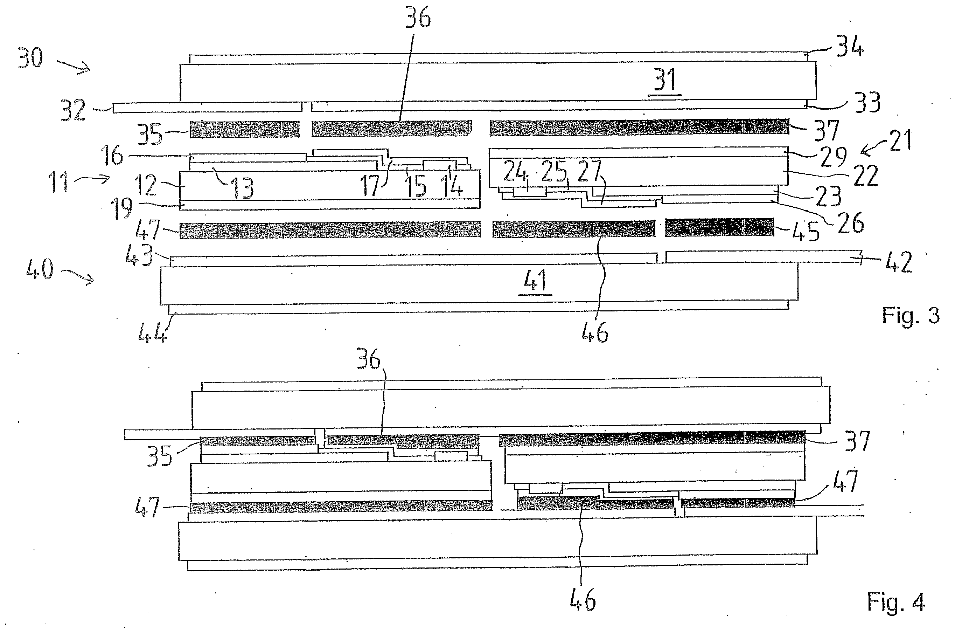

Die in Fig. 3 gezeigte Anordnung wird nachfolgend zusammengedrückt und in einem Lötofen erhitzt, so dass sich das in Fig. 4 gezeigte Bauelement ergibt. Hierbei hat sich das Lot der Lötfolien 36 und 46 derartig verteilt, dass die Abstufungen in den oberen Gate-Metalischichten 17 bzw. 27 nivelliert worden sind.

## Patentansprüche

1. Halbleiterbauelement, insbesondere für Leistungsanwendungen, das aufweist:
einen Halbleiter-Chip (2, 12),
eine auf einer ersten Seite (2a) des Halbleiter-Chips (2, 12) ausgebildete untere erste Hauptelektrodenschicht (3, 13),
eine auf der ersten Seite (2a) ausgebildete untere Steuerelektrodenschicht (4, 14),
eine auf der ersten Seite (2a) zwischen der unteren ersten Hauptelektrodenschicht (3, 13) und der unteren Steuerelektrodenschicht (4, 14) ausgebildete Isolationsschicht (5, 15), die die untere erste Hauptelektrodenschicht (3, 13) teilweise bedeckt,
eine obere erste Hauptelektrodenschicht (6, 16), die auf der unteren ersten Hauptelektrodenschicht (3, 13) ausgebildet ist,
eine obere Steuerelektrodenschicht (7, 17), die auf der unteren Steuerelektrodenschicht (4, 14) und der Isolationsschicht (5, 15) ausgebildet ist und sich auf der Isolationsschicht (5, 15) teilweise oberhalb der unteren ersten Hauptelektrodenschicht (3, 13) erstreckt, und
eine auf einer zweiten Seite (2b) des Halbleiter-Chips (2, 12) ausgebildete zweite Hauptelektrodenschicht (9, 19).

2. Halbleiterbauelement nach Anspruch 1, **dadurch gekennzeichnet, dass** die ersten Hauptelektrodenschichten (13, 16) eine Source-Elektrode bilden, die Steuerelektrodenschichten (14, 17) eine Gate-Elektrode bilden und die zweite Hauptelektrodenschicht (19) eine Drain-Elektrode bildet.

3. Halbleiterbauelement nach Anspruch 1 oder 2, **dadurch gekennzeichnet, dass** zwischen der unteren ersten Hauptelektrodenschicht und der unteren Steuerelektrodenschicht eine Zwischenoxidschicht zur Höhennivellierung vorgesehen ist.

4. Halbleiterbauelementanordnung, die aufweist
ein Halbleiterbauelement (11) nach einem der vorherigen Ansprüche,
eine erste Anschlusseinrichtung (30) mit einem ersten leitfähigen Anschlussbereich (32), der über eine erste Lötschicht (35) mit der oberen ersten Hauptelektrodenschicht des Halbleiterbauelementes (11) verlötet ist, und einem zweiten leitfähigen Anschlussbereich (33), der über eine dritte Lötschicht (36) mit der oberen Steuerelektrodenschicht des Halbleiterbauelementes (11) verlötet ist.

5. Halbleiterbauelementanordnung nach Anspruch 4, **dadurch gekennzeichnet, dass** eine zweite Anschlusseinrichtung (40) mit einem zweiten leitfähigen Anschlussbereich (43) vorgesehen ist, der über eine zweite Lötschicht (47) mit der zweiten Hauptelektrodenschicht (19) des Halbleiterbauelementes (11) verlötet ist.

6. Halbleiterbauelementanordnung nach Anspruch 5, **dadurch gekennzeichnet, dass** mindestens zwei Halbleiterbauelemente (11, 21) zwischen der ersten Anschlusseinrichtung (30) und der zweiten Anschlusseinrichtung (40) in reverser Ausrichtung vorgesehen sind, wobei die zweite Hauptelektrodenschicht (19) des ersten Halbleiterbauelements (11) sowie die obere Steuerelektrodenschicht (27) und die obere erste Hauptelektrodenschicht (26) des zweiten Halbleiterbauelements (21) über Lötschichten (47, 46, 45) mit Anschlussbereichen (43, 42) der zweiten Anschlusseinrichtung (40) verlötet sind und die obere erste Hauptelektrodenschicht (16) und die obere Steuerelektrodenschicht (17) des ersten Halbleiterbauelements (11) sowie die zweite Hauptelektrodenschicht (29) des zweiten Halbleiterbauelements (21) über Lötschichten (35, 36, 37) mit Anschlussbereichen (32, 33) der ersten Anschlusseinrichtung (30) verlötet sind.

7. Halbleiterbauelementanordnung nach Anspruch 6, **dadurch gekennzeichnet, dass** die zweite Hauptelektrodenschicht (19) des ersten Halbleiterbauelements (11) und die obere Steuerelektrodenschicht (27) des zweiten Halbleiterbauelements (21) über Lötschichten (47, 46) mit demselben Anschlussbereich (43) der zweiten Anschlusseinrichtung (40) und die obere Steuerelektrodenschicht (17) des ersten Halbleiterbauelements (11) und die zweite Hauptelektrodenschicht (29) des zweiten Halbleiterbauelements (21) über Lötschichten (36, 37) mit demselben Anschlussbereich (33) der ersten Anschlusseinrichtung (30) verlötet sind.

8. Halbleiterbauelementanordnung nach einem der Ansprüche 4 bis 7, **dadurch gekennzeichnet, dass** die erste und/oder zweite Anschlusseinrichtung (30, 40) ein Substrat, vorzugsweise ein Keramik-Substrat (31, 41), oder eine flexible Folie, mit Metallschichten (32, 33; 42, 43) als leitfähigen Anschlussbereichen aufweist.

9. Halbleiterbauelementanordnung nach Anspruch 8, **dadurch gekennzeichnet, dass** die erste Anschlusseinrichtung (30) und zweite Anschlusseinrichtung (40) Keramik-Substrate (31, 32) mit beidseitigen Metallschichten (32, 33, 34; 42, 43, 44), vorzugsweise DBC-Substrate, sind.

10. Verfahren zum Herstellen einer Halbleiterbauelementanordnung, mit mindestens folgenden Schritten:
a) Herstellen eines Halbleiterbauelementes (11, 21) nach einem der Ansprüche 1 bis 3,
b) Bereitstellen einer ersten Anschlusseinrichtung (30) mit einem ersten leitfähigen Anschlussbereich (32) und einem zweiten leitfähigen Anschlussbereich (33),
c) Vorsehen einer ersten Lötschicht (35) zwischen der oberen ersten Hauptelektrodenschicht (16) und dem ersten leitfähigen Anschlussbereich (32) und einer dritten Lötschicht (36) zwischen der oberen Steuerelektrodenschicht (17) und dem zweiten leitfähigen Anschlussbereich (33), wobei die Lötschichten (35, 36) als Lötfolien (35, 36) zwischengelegt oder als Lötpaste auf die leitfähigen Anschlussbereiche (32, 33) und/oder die Elektrodenschichten flächig aufgetragen werden,
d) Zusammenfügen der Anschlusseinrichtung (30) und des Halbleiter-Chips (11), und
e) Verlöten der oberen ersten Hauptelektrodenschicht (16) mit dem ersten Anschlussbereich sowie der oberen Steuerelektrodenschicht mit dem zweiten Anschlussbereich mittels Erhitzen.

11. Verfahren nach Anspruch 10, **dadurch gekennzeichnet, dass**
in Schritt b) weiterhin eine zweite Anschlusseinrichtung (40) mit einem **zweiten** leitfähigen Anschlussbereich (43) bereitgestellt wird,
in Schritt c) eine zweite Lötschicht (47) als Lötpastenaufdruck auf dem **zweiten** leitfähigen Anschlussbereich (43) oder der zweiten Hauptelektrodenschicht (9, 19) aufgebracht oder als Lötfolie zwischen dem **zweiten** leitfähigen Anschlussbereich (43) und der zweiten Hauptelektrodenschicht (9, 19) positioniert wird, und
in Schritt d) die zweite Hauptelektrodenschicht (9, 19) mit dem **zweiten** Anschlussbereich (43) verlötet wird.

12. Verfahren nach Anspruch 11, **dadurch gekennzeichnet, dass** die zweite Anschlusseinrichtung (40) einen ersten Anschlussbereich (42) und einen zweiten Anschlussbereich (43) aufweist, dass mindestens zwei Halbleiterbauelemente (11, 21) in reverser Ausrichtung zwischen der ersten Anschlusseinrichtung und der zweiten Anschlusseinrichtung angeordnet werden, wobei in Schritt c Lötschichten (35, 36, 37, 45, 46, 47) zwischen jeweils dem oberen ersten Hauptelektrodenschichten und den ersten leitfähigen Anschlussbereichen (32, 42) zwischen den zweiten Hauptelektrodenschichten und den zweiten leitfähigen Anschlussbereichen (33, 43), sowie zwischen den oberen Steuerelektrödenschichten (17, 27) und den zweiten leitfähigen Anschlussbereichen (33, 43) angeordnet sind, und in Schritt d die Halbleiterbauelmente (11, 21) mit den Anschlusseinrichtungen (30, 40) verlötet werden.

13. Verfahren nach einem der Ansprüche 10 bis 12, **dadurch gekennzeichnet, dass** die ersten Hauptelektrodenschichten (13, 16; 23, 26) eine Source-Elektrode zur Kontaktierung eines Source-Bereiches des Halbleiter-Chips (12, 22), die Steuerelektrodenschichten (15, 17; 25, 27) eine Gate-Elektrode und die zweite Hauptelektrodenschicht (19, 29) eine Drain- Elektrode zur Kontaktierung eines Drain-Bereichs des Halbleiter-Chips (12, 22) bilden.

14. Verfahren nach einem der Ansprüche 10 bis 13, **dadurch gekennzeichnet, dass** die Anschlusseinrichtungen (30, 40) mit leitfähigen Anschlussschichten (32, 33, 43) beschichtete Keramik-Substrate (31, 41) und/oder flexible Folien sind.

## Claims

1. Semiconductor component, in particular for power applications, which comprises:
a semiconductor chip (2, 12),
a bottom first main electrode layer (3, 13) formed on a first side (2a) of the semiconductor chip (2, 12),
a bottom control electrode layer (4, 14) formed on the first side (2a),
an insulation layer (5, 15) formed on the first side (2a) between the bottom first main electrode layer (3, 13) and the bottom control electrode layer (4, 14), said insulation layer partly covering the bottom first main electrode layer (3, 13),
a top first main electrode layer (6, 16) formed on the bottom first main electrode layer (3, 13),
a top control electrode layer (7, 17) formed on the bottom control electrode layer (4, 14) and the insulation layer (5, 15) and extending on the insulation layer (5, 15) partly above the bottom first main electrode layer (3, 13), and
a second main electrode layer (9, 19) formed on a second side (2b) of the semiconductor chip (2, 12).

2. Semiconductor component according to Claim 1, **characterized in that** the first main electrode layers (13, 16) form a source electrode, the control electrode layers (14, 17) form a gate electrode, and the second main electrode layer (19) forms a drain electrode.

3. Semiconductor component according to Claim 1 or 2, **characterized in that** an intermediate oxide layer for height levelling is provided between the bottom first main electrode layer and the bottom control electrode layer.

4. Semiconductor component arrangement which comprises
a semiconductor component (11) according to any of the preceding claims,
a first connection device (30) having a first conductive connection region (32), which is soldered to the top first main electrode layer of the semiconductor component (11) by means of a first soldering layer (35), and a second conductive connection region (33), which is soldered to the top control electrode layer of the semiconductor component (11) by means of a third soldering layer (36).

5. Semiconductor component arrangement according to Claim 4, **characterized in that** a second connection device (40) having a second conductive connection region (43) is provided, said second conductive connection region being soldered to the second main electrode layer (19) of the semiconductor component (11) by means of a second soldering layer (47).

6. Semiconductor component arrangement according to Claim 5, **characterized in that** at least two semiconductor components (11, 21) are provided in reverse orientation between the first connection device (30) and the second connection device (40), wherein the second main electrode layer (19) of the first semiconductor component (11) and also the top control electrode layer (27) and the top first main electrode layer (26) of the second semiconductor component (21) are soldered to connection regions (43, 42) of the second connection device (40) by means of soldering layers (47, 46, 45), and the top first main electrode layer (16) and the top control electrode layer (17) of the first semiconductor component (11) and also the second main electrode layer (29) of the second semiconductor component (21) are soldered to connection regions (32,33) of the first connection device (30) by means of soldering layers (35, 36, 37).

7. Semiconductor component arrangement according to Claim 6, **characterized in that** the second main electrode layer (19) of the first semiconductor component (11) and the top control electrode layer (27) of the second semiconductor component (21) are soldered to the same connection region (43) of the second connection device (40) by means of soldering layers (47, 46), and the top control electrode layer (17) of the first semiconductor component (11) and the second main electrode layer (29) of the second semiconductor component (21), are soldered to the same connection region (33) of the first connection device (30) by means of soldering layers (36, 37).

8. Semiconductor component arrangement according to Claims 4 to 7, **characterized in that** the first and/or second connection device (30, 40) comprises a substrate, preferably a ceramic substrate (31, 41), or a flexible film, with metal layers (32, 33; 42, 43) as conductive connection regions.

9. Semiconductor component arrangement according to Claim 8, **characterized in that** the first connection device (30) and second connection device (40) are ceramic substrates (31, 32) with metal layers (32, 33, 34; 42, 43, 44) on both sides, preferably DBC substrates.

10. Method for producing a semiconductor component arrangement, comprising at least the following steps:
a) producing a semiconductor component (11, 21) according to any of Claims 1 to 3,
b) providing a first connection device (30) having a first conductive connection region (32) and a second conductive connection region (33),
c) providing a first soldering layer (35) between the top first main electrode layer (16) and the first conductive connection region (32) and a third soldering layer (36) between the top control electrode layer (17) and the second conductive connection region (33), wherein the soldering layers (35, 36) are interposed as soldering films (35, 36) or are applied as soldering paste on the conductive connection regions (32, 33) and/or the electrode layers in a planar fashion,
d) joining together the connection device (30) and the semiconductor chip (11), and
e) soldering the top first main electrode layer (16) to the first connection region and the top control electrode layer to the second connection region by means of heating.

11. Method according to Claim 10, **characterized in that**
in step b) furthermore a second connection device (40) having a second conductive connection region (43) is provided,
in step c) a second soldering layer (47) is applied as soldering paste implant on the second conductive connection region (43) or the second main electrode layer (9, 19) or is positioned as soldering film between the second conductive connection region (43) and the second main electrode layer (9, 19), and
in step d) the second main electrode layer (9, 19) is soldered to the second connection region (43).

12. Method according to Claim 11, **characterized in that** the second connection device (40) has a first connection region (42) and a second connection region (43), **in that** at least two semiconductor components (11, 21) are arranged in reverse orientation between the first connection device and the second connection device, wherein in step c soldering layers (35, 36, 37, 45, 46, 47) are arranged between respectively the top first main electrode layers and the first conductive connection regions (32, 42) between the second main electrode layers and the second conductive connection regions (33, 43), and also between the top control electrode layers (17, 27) and the second conductive connection regions (33, 43), and in step d the semiconductor components (11, 21) are soldered to the connection devices (30, 40).

13. Method according to any of Claims 10 to 12, **characterized in that** the first main electrode layers (13, 16; 23, 26) form a source electrode for contacting a source region of the semiconductor chip (12, 22), the control electrode layers (15, 17; 25, 27) form a gate electrode, and the second main electrode layer (19, 29) forms a drain electrode for contacting a drain region of the semiconductor chip (12, 22).

14. Method according to any of Claims 10 to 13, **characterized in that** the connection devices (30, 40) are flexible films and/or ceramic substrates (31, 41) coated with conductive connection layers (32, 33, 43).

## Revendications

1. Composant à semi-conducteur, notamment destiné à des applications de puissance, comportant :
une puce semi-conductrice (2, 12),
une première couche d'électrode principale inférieure (3, 13) réalisée sur une première face (2a) de la puce semi-conductrice (2, 12),
une couche d'électrode de commande inférieure (4, 14) réalisée sur la première face (2a),
une couche d'isolation (5, 15) réalisée sur la première face (2a) entre la première couche d'électrode principale inférieure (3, 13) et la couche d'électrode de commande inférieure (4, 14), qui recouvre partiellement la première couche d'électrode principale inférieure (3, 13),
une première couche d'électrode principale supérieure (6, 16) qui est réalisée sur la première couche d'électrode principale inférieure (3, 13),
une couche d'électrode de commande supérieure (7, 17) qui est réalisée sur la couche d'électrode de commande inférieure (4, 14) et la couche d'isolation (5, 15) et qui s'étend sur la couche d'isolation (5, 15) partiellement au-dessus de la première couche d'électrode principale inférieure (3, 13), et
une deuxième couche d'électrode principale (9, 19) réalisée sur une deuxième face (2b) de la puce semi-conductrice (2, 12).

2. Composant à semi-conducteur selon la revendication 1, **caractérisé en ce que** les premières couches d'électrodes principales (13, 16) forment une électrode de source, **en ce que** les couches d'électrodes de commande (14, 17) forment une électrode de grille et **en ce que** la deuxième couche d'électrode principale (19) forme une électrode de drain.

3. Composant à semi-conducteur selon la revendication 1 ou 2, **caractérisé en ce qu'**il est prévu, entre la première couche d'électrode principale inférieure et la couche d'électrode de commande inférieure, une couche d'oxyde intermédiaire destinée à produire un nivellement.

4. Système de composants à semi-conducteur, comportant :
un composant à semi-conducteur (11) selon l'une quelconque des revendications précédentes, un premier dispositif de connexion (30) comportant une première zone de connexion conductrice (32) qui est soudée par l'intermédiaire d'une première couche de soudure (35) à la première couche d'électrode principale supérieure du composant à semi-conducteur (11), et une deuxième zone de connexion conductrice (33) qui est soudée par l'intermédiaire d'une troisième couche de soudure (36) à la couche d'électrode de commande supérieure du composant à semi-conducteur (11).

5. Système de composants à semi-conducteur selon la revendication 4, **caractérisé en ce qu'**il est prévu un deuxième dispositif de connexion (40) comportant une deuxième zone de connexion conductrice (43) qui est soudée par l'intermédiaire d'une deuxième couche de soudure (47) à la deuxième couche d'électrode principale (19) du composant à semi-conducteur (11).

6. Système de composants à semi-conducteur selon la revendication 5, **caractérisé en ce qu'**il est prévu au moins deux composants à semi-conducteur (11, 21) entre le premier dispositif de connexion (30) et le deuxième dispositif de connexion (40) selon une orientation inverse, dans lequel la deuxième couche d'électrode principale (19) du premier composant à semi-conducteur (11) ainsi que la couche d'électrode de commande supérieure (27), et la première couche d'électrode principale supérieure (26) du deuxième composant à semi-conducteur (21) sont soudées par l'intermédiaire de couches de soudure (47, 46, 45) à des zones de connexion (43, 42) du deuxième dispositif de connexion (40) et la première couche d'électrode principale supérieure (16) et la couche d'électrode de commande supérieure (17) du premier composant à semi-conducteur (11) ainsi que la deuxième couche d'électrode principale (29) du deuxième composant à semi-conducteur (21) sont soudées par l'intermédiaire de couches de soudure (35, 36, 37) à des zones de connexion (32, 33) du premier dispositif de connexion (30).

7. Système de composants à semi-conducteur selon la revendication 6, **caractérisé en ce que** la deuxième couche d'électrode principale (19) du premier composant à semi-conducteur (11) et la couche d'électrode de commande supérieure (27) du deuxième composant à semi-conducteur (21) sont soudées par l'intermédiaire de couches de soudure (47, 46) à la même zone de connexion (43) du deuxième dispositif de connexion (40) et **en ce que** la couche d'électrode de commande supérieure (17) du premier composant à semi-conducteur (11) et la deuxième couche d'électrode principale supérieure (29) du deuxième composant à semi-conducteur (21) sont soudées par l'intermédiaire de couches de soudure (36, 37) à la même zone de connexion (33) du premier dispositif de connexion (30).

8. Système de composants à semi-conducteur selon l'une quelconque des revendications 4 à 7, **caractérisé en ce que** le premier et/ou le deuxième dispositif de connexion (30, 40) comporte/comportent un substrat, de préférence un substrat de céramique (31, 41), ou une feuille flexible, muni de couches métalliques (32, 33 ; 42, 43) en tant que zones de connexion conductrices.

9. Système de composants à semi-conducteur selon la revendication 8, **caractérisé en ce que** le premier dispositif de connexion (30) et le deuxième dispositif de connexion (40) sont des substrats de céramique (31, 32) munis sur leurs deux faces de couches métalliques (32, 33, 34 ; 42, 43, 44), de préférence des substrats DBC.

10. Procédé de fabrication d'un système de composants à semi-conducteur, comportant au moins les étapes suivantes :
a) réaliser un composant à semi-conducteur (11, 21) selon l'une quelconque des revendications 1 à 3,
b) fournir un premier dispositif de connexion (30) comportant une première zone de connexion conductrice (32) et une deuxième zone de connexion conductrice (33),
c) prévoir une première couche de soudure (35) entre la première couche d'électrode principale supérieure (16) et la première zone de connexion conductrice (32) et une troisième couche de soudure (36) entre la couche d'électrode de commande supérieure (17) et la deuxième zone de connexion conductrice (33), dans lequel les couches de soudure (35, 36) sont interposées sous la forme de feuilles de soudure (35, 36) ou sont appliquées de manière plane sous la forme de pâte de soudure sur les zones de connexion conductrices (32, 33) et/ou les couches d'électrodes,
d) assembler le dispositif de connexion (30) et la puce semi-conductrice (11), et
e) souder par chauffage la première couche d'électrode principale supérieure (16) à la première zone de connexion, et la couche d'électrode de commande supérieure à la deuxième zone de connexion.

11. Procédé selon la revendication 10, **caractérisé en ce que**,
lors de l'étape b), un deuxième dispositif de connexion (40) comportant une deuxième zone de connexion conductrice (43) est en outre fourni,
lors de l'étape c), une deuxième couche de soudure (47) est déposée sous la forme d'une application de pâte de soudure sur la deuxième zone de connexion conductrice (43) ou la deuxième couche d'électrode de commande principale (9, 19) ou est positionnée sous la forme d'une feuille de soudure entre la deuxième zone connexion conductrice (43) et la deuxième couche d'électrode principale (9, 19), et
lors de l'étape d), la deuxième couche d'électrode principale (9, 19) est soudée à la deuxième zone de connexion (43).

12. Procédé selon la revendication 11, **caractérisé en ce que** le deuxième dispositif de connexion (40) comporte une première zone de connexion (42) et une deuxième zone de connexion (43), **en ce qu'**au moins deux composants à semi-conducteur (11, 21) sont disposés selon une orientation inverse entre le premier dispositif de connexion et le deuxième dispositif de connexion, dans lequel, lors de l'étape c, des couches de soudure (35, 36, 37, 45, 46, 47) sont respectivement disposées entre les premières couches d'électrodes principales supérieures et les premières zones de connexion conductrices (32, 42) entre les deuxièmes couches d'électrodes principales et les deuxièmes zones de connexion conductrices (33, 43), ainsi qu'entre les couches d'électrodes de commande supérieures (17, 27) et les deuxièmes zones de connexion conductrices (33, 43), et **en ce que** lors de l'étape d, les composants à semi-conducteur (11, 21) sont soudés aux dispositifs de connexion (30, 40).

13. Procédé selon l'une quelconque des revendications 10 à 12, **caractérisé en ce que** les premières couches d'électrodes principales (13, 16 ; 23, 26) forment une électrode de source destinée à venir au contact d'une zone de source de la puce semi-conductrice (12, 22), **en ce que** les couches d'électrodes de commande (15, 17 ; 25, 27) forment une électrode de grille et **en ce que** la deuxième couche d'électrode principale (19, 29) forme une électrode de drain destinée à venir au contact d'une zone de drain de la puce semi-conductrice (12, 22).

14. Procédé selon l'une quelconque des revendications 10 à 13, **caractérisé en ce que** les dispositifs de connexion (30, 40) sont des substrats de céramique (31, 41) et/ou des feuilles flexibles revêtues de couches de connexion conductrices (32, 33, 43).
